# EUROPÄISCHE PATENTSCHRIFT

(11) **EP 1 547 163 B1**
(45) Veröffentlichungstag und Bekanntmachung des Hinweises auf die Patenterteilung: **25.07.2007**
(21) Anmeldenummer: 03753330.4
(22) Anmeldetag: 29.09.2003
(51) Int. Cl.: H01L 33/00, H01L 31/0203

(54) **OPTOELEKTRONISCHES BAUELEMENT**
OPTOELECTRONIC COMPONENT
COMPOSANT OPTOELECTRONIQUE

(30) Priorität: 30.09.2002 DE 10245930
(43) Veröffentlichungstag der Anmeldung: 29.06.2005
(73) Patentinhaber: Osram Opto Semiconductors GmbH, 93049 Regensburg (DE); Siemens AG, 80333 München (DE)
(72) Erfinder: BOGNER, Georg, 93138 Lappersdorf (DE); KROMOTIS, Patrick, 10250 Penang (MY); MAYER, Ralf, 67295 Bolanden (DE); NOLL, Heinrich, 64832 Gross-Umstadt (DE); WINTER, Matthias, 93059 Regensburg (DE)
(74) Vertreter: Epping - Hermann - Fischer
(86) Internationale Anmeldenummer: PCT/DE2003/003240
(87) Internationale Veröffentlichungsnummer: WO 2004/032249

(56) Entgegenhaltungen:
- EP-A- 1 139 019
- EP-A- 1 139 439
- EP-A- 1 174 930
- EP-A- 1 182 757
- WO-A-02/33756
- DE-A- 10 246 892
- PATENT ABSTRACTS OF JAPAN Bd. 2003, Nr. 01, 14. Januar 2003 (2003-01-14) & JP 2002 270901 A (CITIZEN ELECTRONICS), 20. September 2002 (2002-09-20)
- PATENT ABSTRACTS OF JAPAN Bd. 0082, Nr. 09 (E-268), 22. September 1984 (1984-09-22) & JP 59 094361 A (TOYODA GOSEI KK), 31. Mai 1984 (1984-05-31)

## Beschreibung

Die vorliegende Erfindung bezieht sich auf ein optoelektronisches Bauelement gemäß dem Oberbegriff des Patentanspruchs 1.

Strahlungsemittierende Halbleiterbauelemente können zur Erzielung eines lichtstarken Gesamtmoduls in einer Matrix angeordnet werden.

Eine solche, als LED-Modul bezeichnete Anordung ist aus der DE 10051159 A1 bekannt. Dabei ist eine Mehrzahl von optoelektronischen Halbleiteranordnungen bzw. Halbleiterchips auf einen Träger montiert, der wiederum auf einem Kühlkörper angeordnet ist. Trotz steigender Packungsdichte der Halbleiterbauelemente kann die entstehende Wärme abgeführt werden. Die entstehende Wärme soll dabei das elektrische Verhalten des Halbleiterbauelements jedoch nicht oder nur unwesentlich beeinflussen. Diese Vorgehensweise setzt aber den Wirkungsgrad des Gesamtmoduls wegen der Absorption der Strahlung benachbarter Halbleiterbauelemente herab.

Durch das Plazieren der einzelnen strahlungsemittierenden Halbleiterbauelemente in einen Reflektor läßt sich die Abstrahl- und Richtungscharakteristik des Moduls verbessern, da seitlich von den einzelnen Halbleiterbauelementen emittierte Strahlung zumindest teilweise in die Hauptabstrahlrichtung umgelenkt wird.

Ein Modul mit einem hohen Wirkungsgrad und einer sehr guten Richtungscharakteristik kann aus einzelnen Halbleiterbauelementen zusammengesetzt werden, die sich jeweils in einem einzelnen Reflektor befinden. Hierbei ist es jedoch schwierig, eine hohe Packungsdichte der Halbleiterbauelemente mitsamt Reflektor im Gesamtmodul zu erhalten. Die Kontaktierungen der Halbleiterbauelemente stehen einer flexiblen Verschaltung und einer hohen Packungsdichte entgegen.

JP 2002-270901 A offenbart ein optoelektronisches Bauelement mit einer strahlungsemittierenden Halbleiteranordnung die in der Kavität eines Grundgehäuse angeordnet ist, wobei in der Kavität zwischen der Halbleiteranordnung und Seitenwänden der Kavität eine reflektierende Füllmasse angeordnet ist.

Der vorliegenden Erfindung liegt daher die Aufgabe zugrunde, ein optoelektronisches Bauelement und Bauelement-Modul zur Verfügung zu stellen, das eine enge Anordnung von benachbarten Halbleiterbauelementen bzw. optoelektronischen Halbleiteranordnungen ermöglicht.

Insbesondere liegt die Aufgabe zugrunde, ein Halbleiterbauelement mit einer Kontaktierungsanordnung zur Verfügung zu stellen, die eine Trennung der thermischen von der elektrischen Leitung ermöglicht.

Diese Aufgabe wird mit den Merkmalen des Anspruchs 1 gelöst. Weitere Merkmale von vorteilhaften Ausgestaltungen und Weiterbildungen des erfindungsgemäßen optoelektronischen Bauelements sind in den abhängigen Ansprüchen 2 bis 16 angegeben.

Die Erfindung sieht ein optoelektronisches Bauelement mit einer elektromagnetische Strahlung emittierenden und/oder empfangenden Halbleiteranordnung vor, die auf einem Träger angeordnet ist, der thermisch leitend mit einem Kühlkörper verbunden ist. Bonddrähte verbinden die externen elektrischen Anschlüsse mit den Anschlüssen der Halbleiteranordnung. Die externen elektrischen Anschlüsse sind elektrisch isoliert auf dem Kühlkörper mit Abstand zu dem Träger angeordnet.

Dies hat den Vorteil, dass die elektrischen Leitungsverbindungen von der thermischen Leitung weitgehend entkoppelt sind. Durch den thermischen Anschluss einer Halbleiteranordnung bzw. eines Chips auf dem Kühlkörper mittels des Trägers können viele Chips auf dem Kühlkörper dicht angeordnet und die Wärme abgeführt werden. Die elektrische Kontaktierung der Chips kann flexibel über die vom Kühlkörper isolierten Anschlüsse geführt werden. Weiters können auf den externen elektrischen Anschlüssen kompakte Reflektorgehäuse angebracht werden, was den Platzbedarf des Bauelements verringert und eine hohe Lichtausbeute ermöglicht.

Diese Vorgehensweise hat den Vorteil, daß der elektrische Stromfluß nicht über den Kühlkörper verläuft, der die im Betrieb des Halbleiterbauelements entstehende Wärme abführt.

Es ist vorteilhaft, wenn der Träger ein Trägersubstrat und mindestens eine darauf angeordnete elektrisch isolierende Schicht enthält. Alternativ ist das Trägermaterial selbst elektrisch isolierend. Dann muss die Halbleiteranordnung nicht gegen den Träger separat isoliert sein und kann auf einem leitfähigen Substrat angeordnet sein, ohne dass ein Kurzschluss untereinander oder zum Kühlkörper entsteht.

Zwischen der Halbleiteranordnung und der elektrisch isolierenden Schicht kann eine elektrisch leitende Schicht angeordnet sein, die mit einem externen elektrischen Anschluss verbunden ist. Dies ist insbesondere für eine Halbleiteranordnung auf einem leitfähigen Substrat zweckmäßig, weil ein Anschluss der Halbleiteranordnung mittels eines Bonddrahts über die elektrisch leitende Schicht geführt werden kann.

Es ist besonders vorteilhaft, wenn die externen elektrischen Anschlüsse Leiterbahnen einer Leiterplatte enthalten. Die Leiterplatte enthält ein isolierendes Substrat mit einer Leiterbahn und kann deshalb direkt auf den Kühlkörper aufgebracht werden. Es können auch mehrere Leiterplatten übereinander angeordnet sein, die dann auch gegeneinander isoliert sind.

Leiterbahnen, die auf unterschiedlichen übereinander angeordneten Leiterplatten mittels Durchkontaktierungen untereinander verbindbar sind, erhöhen die Flexibilität der Verschaltung vieler optoelektronischer Bauelemente weiter.

Es ist mit Vorteil vorgesehen, dass das Trägersubstrat mindestens ein gut wärmeleitendes Material aus der Gruppe bestehend aus Si, diamantbeschichtetem Si, Diamant, SiC, AlN und BN aufweist.

Weiter ist es vorteilhaft, wenn die elektrisch isolierende Schicht SiO₂ aufweist. Dies ist besonders vorteilhaft der Fall, wenn die Trägerschicht Silizium aufweist.

Diese in der Halbleitertechnik verwendeten Materialien verringern bei einer Vielzahl von Bauelementen die Spannungen untereinander und zu den Halbleiterchips selbst.

In einer vorteilhaften Ausbildung ist die Halbleiteranordnung auf den Träger mit Hilfe eines metallischen Lots oder eines thermisch und/oder elektrisch leitfähigen Klebstoffs aufgebracht.

Eine gute thermische Wärmeleitung bzw. -abfuhr ergibt sich, wenn der Träger auf dem Kühlkörper mit Hilfe eines metallischen Lots oder eines thermisch leitfähigen Klebstoffs aufgebracht ist.

Eine sehr gute Lichtabstrahlung wird möglich, wenn die Halbleiteranordnung und der Träger in einem Grundgehäuse angeordnet sind, das reflektierende Eigenschaften hat.

Sehr gut und individuell an den Chip anpassbar wird die Lichtabstrahlung, wenn das Grundgehäuse genau eine Halbleiteranordnung enthält. Dann sinkt nicht durch Absorption einer benachbarten Halbleiteranordnung innerhalb der Kavität der externe Wirkungsgrad des Halbleiterbauelements.

Das optoelektronische Bauelement gemäß der Erfindung weist in dem Grundgehäuse eine Kavität bzw. Aussparung auf, in der die elektromagnetische Strahlung emittierende und/oder empfangende Halbleiteranordnung angeordnet ist. Der Reflektor ist anders als bei herkömmlichen optoelektronischen Bauelementen zumindest nicht allein durch reflektierende Seitenflächen der Kavität des Grundgehäuses selbst, sondern zumindest zum Teil durch eine in die Kavität eingefüllte reflektierende Füllmasse realisiert. Das Material und die Menge der Füllmasse sind dazu derart gewählt, dass sich die Füllmasse beim und/oder nach dem Einfüllen aufgrund der Adhäsionskraft zwischen dem Material der Füllmasse und dem Material der Seitenflächen der Kavität an diesen Seitenflächen hochzieht und eine parabolartig geformte Oberfläche ausbildet. Diese zur Vorderseite des Gehäuses hin gewandte Oberfläche der Füllmasse dient als Reflektorfläche für eine von dem Halbleiteranordnung emittierte und/oder empfangene elektromagnetische Strahlung.

Mit anderen Worten wird die Kavität mit der Füllmasse teilweise gefüllt und aufgrund der Adhäsionskraft zwischen Füllmasse und Grundgehäuse bildet die Füllmasse von selbst eine konkave Oberfläche in der Kavität aus, da die Füllmasse an den seitlichen Innenflächen der Kavität des Grundgehäuses hoch kriecht. Die so gebildeten parabolartigen Innenflächen der Füllmasse bilden den Reflektor für die in die Kavität eingesetzte Halbleiteranordnung.

Diese Reflektorflächen können auch bei sehr kleinen Öffnungen der Kavitäten einfach durch geeignete Dosierung der Füllmasse in der Kavität erzeugt werden. Dadurch verhalten sich die Seitenwände des Gehäuses und die Füllmasse wie ein einzelner Reflektor, was die Lichtabstrahlungsleistung weiter verbessert. Außerdem werden die in der Kavität vorhandenen Leiterbahnen, Verdrahtungen und dergleichen durch die Füllmasse ohne Beeinträchtigung deren Funktionsweise umhüllt.

Somit können mit der erfindungsgemäßen Maßnahme selbst bei optoelektronischen Bauelementen mit engen Öffnungen der Kavität und/oder komplexen Halbleiteranordnung- und Verdrahtungsanordnungen in der Kavität innerhalb der Kavität Reflektoren vorgesehen und damit der externe Wirkungsgrad der Bauelemente gesteigert werden.

Es ist besonders vorteilhaft, wenn das Grundgehäuse auf der der Halbleiteranordnung zugewandten Innenseite schräg ausgebildet ist, so daß das Grundgehäuse eine Reflektorfläche für einen Teil der vom Halbleiteranordnung ausgesandten Strahlung aufweist.

Als Füllmasse ist bevorzugt TiO₂ oder ein mit TiO₂-Partikeln gefülltes Epoxidharz oder Silikon vorgesehen.

Weiter ist vorgesehen, dass die Kavität des Gehäuses zumindest zum Teil mit einer strahlungsdurchlässigen Einkapselungsmasse gefüllt ist. Dadurch wird erstens ein Schutz des Chips und seiner Anschlüsse möglich. Weiter können bei entsprechender Wahl des Chips und der Einkapselungsmasse Bauelemente unterschiedlicher Farben hergestellt werden. Beispielsweise weiß abstrahlende Bauelemente durch einen Chip auf GaN-Basis und eine Einkapselungsmasse, die YAG:Ce-Partikel enthält.

Diese Einkapselungsmasse kann vorteilhafterweise Epoxidharz oder Silikon aufweisen. Bei der Verwendung von Silikon können mechanische Spannungen im Halbleiterbauelement oder in einem aus einzelnen Halbleiterbauelementen bestehenden Modul gut verringert werden.
Vorzugsweise sind die externen Anschlüsse zumindest teilweise zwischen dem Grundgehäuse und dem Kühlkörper angeordnet. Dies ermöglicht ein besonders platzsparendes Verschalten der optoelektronischen Bauelemente.

Bevorzugt werden bei der Erfindung als Halbleiteranordnung Hochleistungchips eingesetzt. Hierbei ist das Bauelement für eine elektrische Leistungsaufnahme von mindestens 0,5 W vorgesehen. In einer weiteren vorteilhaften Variante ist das Bauelement für eine elektrische Leistungsaufnahme von mindestens 1 W vorgesehen. In einer besonders vorteilhaften Variante ist das Bauelement für eine elektrische Leistungsaufnahme von mindestens 3 W vorgesehen.

Aufgrund der Entkopplung von thermischer und elektrischer Leitung erfordert die Erfindung weiterhin einen vorteilhaft geringen Platzbedarf, wobei auch bei der Verwendung von Hochleistungschips die Grundfläche des Bauelements bevorzugt kleiner oder gleich 1 cm² ist.

Besonders vorteilhaft lassen sich im Rahmen der Erfindung die mehreren erfindungsgemäßen optoelektronischen Bauelemente zu einem Modul anordnen. In einem derartigen Modul sind die optoelektronischen Bauelemente vorzugsweise matrixförmig angeordnet und zumindest teilweise in Reihe geschaltet.

Für mehrere optoelektronische Bauelemente ist dabei jeweils ein Grundgehäuse vorgesehen.

Bei einer besonders bevorzugten Ausführungsform der Erfindung ist die der Halbleiteranordnung zugewandte oberste Schicht des Trägers elektrisch leitfähig. Bevorzugt weist diese elektrisch leitfähige Schicht im wesentlichen ein Metall auf.

Vorzugsweise sind die optoelektronischen Bauelemente zumindest teilweise durch Leiterbahnen, die insbesondere teilweise zwischen Grundgehäuse und Kühlkörper angeordnet sein können, miteinander elektrisch leitend verbunden. Die Leiterbahnen zum Anschluss der Halbleiterchips erlauben ein sehr platzsparendes Verschalten der optoelektronischen Bauelemente mit einem benachbarten Bauelement. Es wird kein Bonddraht über den Rand des Grundgehäuses geführt. Die Leiterbahnen lassen komplexe Verschaltungen von Bauelementen zu. Die Leiterbahnen können sich in einer Leiterplatte (z.B. FR4, flexible Leiterplatte) befinden, die entsprechende Aussparungen aufweist. Die Leiterplatte kann mehrlagig ausgebildet sein, so daß zusätzlich zu Leiterbahnen weitere funktionelle Elemente in einem mehrlagigen Aufbau vorhanden sein können.

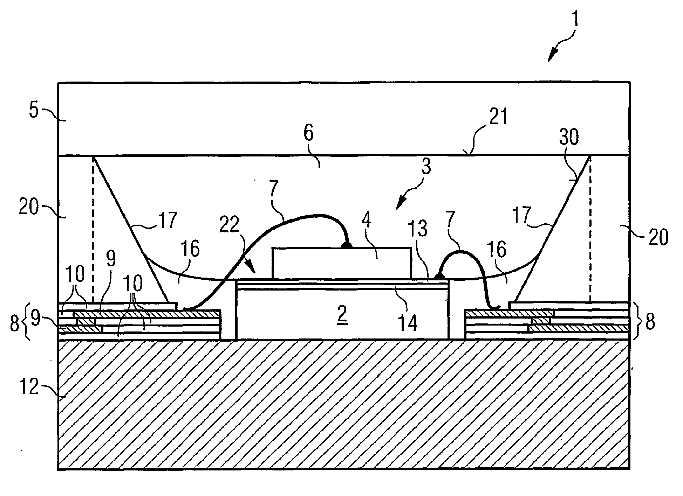

Weitere Vorteile und vorteilhafte Weiterbildungen des erfindungsgemäßen optoelektronischen Bauelements ergeben sich aus den im folgenden in Verbindung mit der Figur beschriebenen Ausführungsbeispielen.

Die Figur zeigt eine schematische Darstellung einer Schnittansicht des Ausführungsbeispiels.

Bei dem optoelektronischen Bauelement 1 gemäß der Figur ist eine elektromagnetische Strahlung emittierende und/oder empfangende Halbleiteranordnung 4 auf einem Träger 22 angeordnet. Der Träger 22 ist thermisch leitend mit einem Kühlkörper 12 aus z.B. Kupfer, Aluminium oder Molybdän verbunden. Externe elektrische Anschlüsse 9 sind über Bonddrähte 7 elektrisch mit der Halbleiteranordnung 4 bzw. mit einer elektrisch leitenden Schicht 13 verbunden. Die elektrisch leitende Schicht 13 kontaktiert die Unterseite der Halbleiteranordnung 4, die so aufgebaut ist, dass ein Strom vertikal durch die Anordnung fließen kann, z.B. indem das Substrat für die die Lichterzeugung bewirkende aktive Schicht leitfähig ist.

In einer anderen Ausführung mit isolierendem Substrat für die aktive Schicht ist der zweite Bonddraht ebenfalls zum Halbleiterchip direkt geführt.

In der Figur ist die elektrisch leitende Schicht 13 mittels einer elektrisch isolierenden Schicht 14 vom Trägersubstrat 2 des Trägers 22 isoliert. Die elektrisch isolierende Schicht 14 kann bevorzugt zweilagig sein und aus Siliziumoxid und einer darüber aufgebrachten Passivierungsschicht, z.B. aus Siliziumnitrid bestehen, die das bevorzugt aus Silizium oder Galliumarsenid bestehende, thermisch gut leitende Trägersubstrat von der elektrisch leitenden Schicht 13 elektrisch trennt. Als Trägersubstrat kommen auch gut wärmeleitende keramikartige Materialien in Frage wie Aluminiumnitrid oder Bornitrid oder Karbide. Der Träger 22 ist durch eine Lötverbindung oder eine Klebung direkt auf einem Kühlkörper 12 aus Aluminium, Kupfer oder Molybdän aufgebracht. Bei einer elektrischen Leistungsaufnahme des Bauelements von mindestens 0,5 W und einer Grundfläche des Bauelements von höchstens 1 cm² kann die entstehende Wärme bei der beschriebenen Trennung von Wärme- und Stromfluss effektiv vom Bauelement abgeführt werden. In einer anderen Ausführung ist eine Leistungsaufnahme des Bauelements von mindestens 1 W oder sogar mindestens 3 W vorgesehen.

Ebenfalls direkt auf dem Kühlkörper 12 sind externe elektrischen Anschlüsse 9 elektrisch isoliert und mit Abstand zu dem Träger 22 angeordnet. Die externen elektrischen Anschlüsse 9 sind bevorzugt Leiterbahnen von übereinander angeordneten Leiterplatten 10, die die Anschlussanordnung 8 bilden. Mindestens ist für die zwei Chipanschlüsse eine Leiterplatte erforderlich. Mehrere Chips in einem Modul werden bevorzugt durch mehrlagige Leiterplatten verbunden, die eine flexible Verschaltung, beispielsweise eine Reihenschaltung von matrixartig angeordneten Bauelementen ermöglichen. Die Verbindung unterschiedlicher Leiterbahnen verschiedener Leiterplatten erfolgt über Durchkontaktierungen jeweils zwischen dem Grundgehäuse 20 und dem Kühlkörper 12 eines optoelektronischen Bauelements.

Die Halbleiteranordnung 4 mit dem Träger 22 befindet sich in einem Grundgehäuse 20 mit einer Aussparung oder Kavität 3.

Das Grundgehäuse kann ein Rahmen sein, der auf den Leiterplatten 8 mit den elektrischen Anschlüssen 9 aufgebracht ist. Dies ermöglicht eine sehr kompakte Bauform des erfindungsgemäßen Bauelements 1. Dies ermöglicht weiter die Ausbildung der Innenseite 17 des Grundgehäuses 20 als Reflektor 30, um möglichst viel und möglichst gerichtetes Licht aus dem Bauelement auszukoppeln.

Zwischen dem Halbleiterchip 4 und den Seitenwänden 17 der Kavität 3 ist eine reflektierende Füllmasse 16 eingefüllt, die beispielsweise aus mit TiO₂-Partikeln gefülltem Epoxidharz besteht, wobei der Anteil an TiO₂ in der Füllmasse 16 ausreicht, das Reflexionsvermögen der Füllmasse signifikant zu erhöhen. Die Füllmasse reicht chipseitig bis etwa zur Oberkante des Trägers 22. Vorzugsweise liegt der Anteil an TiO₂ in der Füllmasse 16 zwischen etwa 10 und 50 Vol.-%. Partikel aus Zirkondioxid, Zinkoxid, Bariumsulfate, Galliumnitrid, Alluminiumoxid oder einer Mischung von zumindest zwei dieser sind auch für den Einsatz mit einem Epoxidharz in der Füllmasse 16 geeignet. Wichtig ist, dass der Brechungsindexunterschied zwischen dem Epoxidharz und den Partikeln genügend groß ist, dass die Reflektivität der Füllmasse steigt.

Die zur Vorderseite 21 des Grundgehäuses 20 hin gewandte Oberfläche der Füllmasse ist vom Halbleiterchip 4 aus gesehen konvex gekrümmt und bildet eine Reflektorfläche zumindest für einen Teil der seitlich emittierten und/oder empfangenen Strahlung aus.

Der oberhalb der Füllmasse liegende freie Oberflächenbereich des Halbleiterchips 4 ist von einer strahlungsdurchlässigen Einkapselungsmasse 6 bedeckt und besteht beispielweise wiederum aus einem Epoxidharz oder einem anderen geeigneten Reaktionsharz.

Wie in der Schnittansicht der Figur erkennbar, ist die Füllhöhe der Füllmasse 16 benachbart zu dem Halbleiterchip 4, d.h. benachbart zum Träger 22 gering. Auf diese Weise ergibt sich eine zur Vorderseite hin im wesentlichen parabolartig öffnende Form der Oberfläche der Füllmasse 16 in Verbindung mit der Oberfläche 30 der Seitenwand des Gehäuses 20. Diese Form ergibt sich bei geeigneter Wahl des Materials und der Dosierung der Füllmasse automatisch aufgrund der Adhäsionskräfte zwischen der Füllmasse und dem Material des Gehäuserahmens 20. Die von den Halbleiterchips 4 gesehen konkav gekrümmten Innenflächen der Füllmasse 16 dienen als Reflektor für die von den Halbleiterchips 4 seitlich emittierte und/oder empfangene Strahlung.

Das Reflexionsvermögen der Füllmasse 16 mit dem darin enthaltenen TiO₂-Anteil beträgt bis zu etwa 80%. Im Vergleich zu einem optoelektronischen Bauelement, bei dem die Kavität ausschließlich mit einer transparenten Füllmasse gefüllt ist, konnte mit dem optoelektronischen Bauelement 1 der vorliegenden Erfindung der externe Wirkungsgrad erheblich gesteigert werden.

Zum Schutz der Halbleiterchips 4 ist die Kavität 3 vollständig mit einer strahlungsdurchlässigen, beispielsweise transparenten Einkapselungsmasse 6 gefüllt, welche den Halbleiterchip 4 umhüllt und für die von den Halbleiterchips 4 zu emittierende bzw. zu empfangende Strahlung durchlässig ist. Für diese Einkapselungsmasse 6 können wie bei den herkömmlichen Bauelementen geeignete Füllmassen aus transparenten Kunstharzen, wie beispielsweise Epoxidharz, oder aus Polycarbonat verwendet werden, die vorzugsweise besonders auf die Eigenschaften der Füllmasse abgestimmt ist.

Die obige Beschreibung der Erfindung anhand der Ausführungsbeispiele ist selbstverständlich nicht als Einschränkung der Erfindung auf diese zu verstehen. Vielmehr ist der in den Ansprüchen 1 und 25 dargelegte Erfindungsgedanke bei einer Vielzahl von verschiedensten Bauformen anwendbar.

## Patentansprüche

1. Optoelektronisches Bauelement (1) mit einer elektromagnetische Strahlung emittierenden und/oder empfangenden Halbleiteranordnung (4), die auf einem Träger (22) angeordnet ist, der thermisch leitend mit einem Kühlkörper (12) verbunden ist, und mit externen elektrischen Anschlüssen (9), die mit der Halbleiteranordnung (4) verbunden sind, wobei
die externen elektrischen Anschlüsse (9) elektrisch isoliert auf dem Kühlkörper (12) mit Abstand zu dem Träger (22) angeordnet sind, und wobei die Halbleiteranordnung (4) und der Träger (22) in der Kavität (3) eines Grundgehäuses (20) angeordnet sind,
**dadurch gekennzeichnet, daß**
in der Kavität (3) zwischen der Halbleiteranordnung (4) und Seitenwänden (17) der Kavität eine reflektierende Füllmasse (16) angeordnet ist, die von der Halbleiteranordnung (4) aus zu der Vorderseite (21) des Grundgehäuses (20) hin gesehen eine konkav gekrümmte Oberfläche aufweist, die eine Reflektorfläche für einen Teil der Strahlung ausbildet.

2. Optoelektronisches Bauelement nach Anspruch 1,
**dadurch gekennzeichnet, daß**
der Träger (22) ein Trägersubstrat (2) und mindestens eine darauf angeordnete elektrisch isolierende Schicht (14) enthält.

3. Optoelektronisches Bauelement nach Anspruch 2,
**dadurch gekennzeichnet, daß**
zwischen der Halbleiteranordnung (4) und der elektrisch isolierenden Schicht (14) eine elektrisch leitende Schicht (13) angeordnet ist, die mit einem der externen elektrischen Anschlüsse (9) verbunden ist.

4. Optoelektronisches Bauelement nach einem der Ansprüche 1 bis 3,
**dadurch gekennzeichnet, daß**
die Halbleiteranordnung (4) einen Halbleiterchip enthält.

5. Optoelektronisches Bauelement nach einem der Ansprüche 1 bis 4,
**dadurch gekennzeichnet, daß**
die externen elektrischen Anschlüsse (9) Leiterbahnen einer Leiterplatte (10) enthalten.

6. Optoelektronisches Bauelement nach Anspruch 5,
**dadurch gekennzeichnet, daß**
Leiterbahnen auf unterschiedlichen übereinander angeordneten Leiterplatten (10) mittels Durchkontaktierungen untereinander verbindbar sind.

7. Optoelektronisches Bauelement nach einem der Ansprüche 2 bis 6,
**dadurch gekennzeichnet, daß**
das Trägersubstrat (2) mindestens ein wärmeleitendes Material aus der Gruppe bestehend aus Si, diamantbeschichtetem Si, Diamant, SiC, AlN und BN aufweist.

8. Optoelektronisches Bauelement nach einem der Ansprüche 2 bis 7,
**dadurch gekennzeichnet, daß**
die elektrisch isolierende Schicht (14) SiO₂ aufweist.

9. Optoelektronisches Bauelement nach einem der Ansprüche 1 bis 8,
**dadurch gekennzeichnet, daß**
der Halbleiteranordnung (4) auf den Träger (22) mit Hilfe eines metallischen Lots oder eines thermisch und/oder elektrisch leitfähigen Klebstoffs aufgebracht ist.

10. Optoelektronisches Bauelement nach einem der Ansprüche 1 bis 9,
**dadurch gekennzeichnet, daß**
der Träger (22) auf dem Kühlkörper (12) mit Hilfe eines metallischen Lots oder eines thermisch leitfähigen Klebstoffs aufgebracht ist.

11. Optoelektronisches Bauelement nach einem der Ansprüche 1 bis 10,
**dadurch gekennzeichnet, daß**
in der Kavität (3) des Grundgehäuses (20) genau eine Halbleiteranordnung (4) angeordnet ist.

12. Optoelektronisches Bauelement nach einem der Ansprüche 1 bis 11,
**dadurch gekennzeichnet, daß**
die Seitenwänden (17) der Kavität schräg ausgebildet sind und eine Reflektorfläche (30) für einen Teil der von der Halbleiteranordnung (4) ausgesandten Strahlung bilden.

13. Optoelektronisches Bauelement nach einem der Ansprüche 1 bis 12,
**dadurch gekennzeichnet, daß**
die Füllmasse (16) TiO₂ oder ein mit TiO₂-Partikeln gefülltes Epoxidharz enthält.

14. Optoelektronisches Bauelement nach einem der Ansprüche 1 bis 13,
**dadurch gekennzeichnet, daß**
der Halbleiteranordnung (4) zumindest zum Teil mit einer strahlungsdurchlässigen Einkapselungsmasse (6) eingekapselt ist.

15. Optoelektronisches Bauelement nach einem der Ansprüche 1 bis 14,
**dadurch gekennzeichnet, daß**
die externen Anschlüsse (9) zumindest teilweise zwischen dem Grundgehäuse (20) und dem Kühlkörper (12) angeordnet sind.

16. Optoelektronisches Bauelement nach einem der Ansprüche 1 bis 15,
**dadurch gekennzeichnet, daß**
es eine Grundfläche von höchstens 1 cm² besitzt.

## Claims

1. Optoelectronic component (1) having a semiconductor arrangement (4) which emits and/or receives electromagnetic radiation and which is arranged on a support (22) which is thermally conductively connected to a heat sink (12), and having external electrical connections (9) which are connected to the semiconductor arrangement (4),
the external electrical connections (9) being arranged in electrically insulated fashion on the heat sink (12) at a distance from the support (22), and the semiconductor arrangement (4) and the support (22) being arranged in the cavity (3) of a basic housing (20),
**characterized in that**
the cavity (3) between the semiconductor arrangement (4) and lateral walls (17) of the cavity contains a reflective filling compound (16) which, as seen from the semiconductor arrangement (4) toward the front (21) of the basic housing (20), has a concave surface which forms a reflective area for a portion of the radiation.

2. Optoelectronic component according to Claim 1,
**characterized in that**
the support (22) contains a support substrate (2) and at least one electrically insulating layer (14) arranged thereon.

3. Optoelectronic component according to Claim 2,
**characterized in that**
the semiconductor arrangement (4) and the electrically insulating layer (14) have an electrically conductive layer (13) arranged between them which is connected to one of the external electrical connections (9).

4. Optoelectronic component according to one of Claims 1 to 3,
**characterized in that**
the semiconductor arrangement (4) contains a semiconductor chip.

5. Optoelectronic component according to one of Claims 1 to 4,
**characterized in that**
the external electrical connections (9) include conductor tracks on a printed circuit board (10).

6. Optoelectronic component according to Claim 5,
**characterized in that**
conductor tracks on different printed circuit boards (10) arranged above one another can be connected to one another by means of plated-through holes.

7. Optoelectronic component according to one of Claims 2 to 6,
**characterized in that**
the support substrate (2) has at least one material with thermal conductivity from the group comprising Si, diamond-coated Si, diamond, SiC, AIN and BN.

8. Optoelectronic component according to one of Claims 2 to 7,
**characterized in that**
the electrically insulating layer (14) comprises SiO₂.

9. Optoelectronic component according to one of Claims 1 to 8,
**characterized in that**
the semiconductor arrangement (4) is attached to the support (22) by means of a metal solder or a thermally and/or electrically conductive adhesive.

10. Optoelectronic component according to one of Claims 1 to 9,
**characterized in that**
the support (22) is attached to the heat sink (12) by means of a metal solder or a thermally conductive adhesive.

11. Optoelectronic component according to one of Claims 1 to 10,
**characterized in that**
the cavity (3) of the basic housing (20) contains precisely one semiconductor arrangement (4).

12. Optoelectronic component according to one of Claims 1 to 11,
**characterized in that**
the lateral walls (17) of the cavity are formed at an angle and form a reflective area (30) for a portion of the radiation emitted by the semiconductor arrangement (4).

13. Optoelectronic component according to one of Claims 1 to 12,
**characterized in that**
the filling compound (16) contains TiO₂ or an epoxy resin filled with TiO₂ particles.

14. Optoelectronic component according to one of Claims 1 to 13,
**characterized in that**
the semiconductor arrangement (4) is at least partly encapsulated by a radiation-pervious encapsulation compound (6).

15. Optoelectronic component according to one of Claims 1 to 14,
**characterized in that**
at least some of the external connections (9) are arranged between the basic housing (20) and the heat sink (12).

16. Optoelectronic component according to one of Claims 1 to 15,
**characterized in that**
it has a base area of no more than 1 cm².

## Revendications

1. Composant (1) optoélectronique comprenant un dispositif (4) à semiconducteurs émettant et/ou recevant du rayonnement électromagnétique et disposé sur un support (22) qui est relié d'une manière thermiquement conductrice à un refroidisseur (12), et des bornes (9) électriques qui sont reliées au dispositif (4) à semiconducteurs, les bornes (9) électriques extérieures étant montées isolées du point de vue électrique sur le refroidisseur (12) en étant à distance du support (22), et le dispositif (4) à semiconducteurs et le support (22) étant disposés dans la cavité (3) d'un boîtier (20) de base,
**caractérisé en ce qu'**il est disposé dans la cavité (3), entre le dispositif (4) à semiconducteurs et les parois (17) latérales de la cavité, une composition (16) de remplissage réfléchissante qui comporte, considérée du dispositif (4) à semiconducteurs au côté (21) avant du boîtier (20) de base, une surface concave qui constitue une surface de réflecteur pour une partie du rayonnement.

2. Composant optoélectronique suivant la revendication 1,
**caractérisé en ce que** le support (22) comporte un substrat (2) de support et au moins une couche (14) isolante du point de vue électrique qui est disposée dessus.

3. Composant optoélectronique suivant la revendication 2,
**caractérisé en ce qu'**entre le dispositif (4) à semiconducteurs et la couche (14) isolante du point de vue électrique, est disposée une couche (13) conductrice de l'électricité qui est reliée à l'une des bornes (9) électriques extérieures.

4. Composant optoélectronique suivant l'une des revendications 1 à 3,
**caractérisé en ce que** le dispositif (4) à semiconducteurs comporte une puce à semiconducteurs.

5. Composant optoélectronique suivant l'une des revendications 1 à 4,
**caractérisé en ce que** les bornes (9) électriques extérieures comportent des pistes conductrices d'une plaquette (10) à circuit imprimé.

6. Composant optoélectronique suivant la revendication 5,
**caractérisé en ce que** les pistes conductrices sur des plaquettes (10) à circuit imprimé différentes et superposées peuvent être reliées les unes aux autres au moyen de traversées.

7. Composant optoélectronique suivant l'une des revendications 2 à 6,
**caractérisé en ce que** le substrat (2) de support comporte au moins un matériau conducteur de la chaleur choisi dans le groupe constitué de Si, de Si revêtu de diamant, de diamant, de SiC, d'AlN et de BN.

8. Composant optoélectronique suivant l'une des revendications 2 à 7,
**caractérisé en ce que** la couche (14) isolante du point de vue électrique comporte du SiO₂.

9. Composant optoélectronique suivant l'une des revendications 1 à 8,
**caractérisé en ce que** le dispositif (4) à semiconducteurs est déposé sur le support (22) à l'aide d'une brasure métallique ou d'une colle conductrice du point de vue thermique et/ou du point de vue électrique.

10. Composant optoélectronique suivant l'une des revendications 1 à 9,
**caractérisé en ce que** le support (22) est déposé sur le refroidisseur (12) à l'aide d'une brasure métallique ou d'une colle conductrice du point de vue thermique.

11. Composant optoélectronique suivant l'une des revendications 1 à 10,
**caractérisé en ce qu'**exactement un dispositif (4) à semiconducteurs est disposé dans la cavité (3) du boîtier (20) de base.

12. Composant optoélectronique suivant l'une des revendications 1 à 11,
**caractérisé en ce que** les parois (17) latérales de la cavité étant inclinées, il se forme une surface (30) de réflecteur sur une partie du rayonnement émis par le dispositif (4) à semiconducteurs.

13. Composant optoélectronique suivant l'une des revendications 1 à 12,
**caractérisé en ce que** la composition (16) de remplissage contient du TiO₂ ou une résine époxyde chargée de particules de TiO₂.

14. Composant optoélectronique suivant l'une des revendications 1 à 13,
**caractérisé en ce que** le dispositif (4) à semiconducteurs est encapsulé au moins en partie d'une composition (6) d'encapsulation transparente au rayonnement.

15. Composant optoélectronique suivant l'une des revendications 1 à 14,
**caractérisé en ce que** les bornes (9) extérieures sont disposées au moins en partie entre le boîtier (20) de base et le refroidisseur (12).

16. Composant optoélectronique suivant l'une des revendications 1 à 15,
**caractérisé en ce qu'**il a une surface de base de 1 cm² au plus.
